# EUROPÄISCHE PATENTANMELDUNG

(11) **EP 4 350 998 A1**
(43) Veröffentlichungstag der Anmeldung: **10.04.2024**
(21) Anmeldenummer: 23196729.0
(22) Anmeldetag: 12.09.2023
(51) Int. Cl.: H03K 17/30, H03K 17/0812, H03K 17/12, H03K 17/284, H03K 17/08, H03K 17/06, H03K 17/16, H02M 1/088, H03K 17/14

(54) **VERFAHREN UND VORRICHTUNG ZUM BETREIBEN EINER HALBBRÜCKENSCHALTUNG AUS DISKRETEN MOSFETS**

(30) Priorität: 07.10.2022 DE 102022210614
(71) Anmelder: Volkswagen Aktiengesellschaft, 38440 Wolfsburg (DE)
(72) Erfinder: Arnaout, Samy, 34305 Niedenstein (DE)

(57) **Zusammenfassung**

Die Erfindung betrifft ein Verfahren zum Betreiben einer Halbbrückenschaltung (2) aus diskreten MOSFETs (T1 - T4), wobei die Halbbrückenschaltung (2) mindestens zwei parallelgeschaltete High-Side-Schalter und mindestens zwei parallelgeschaltete Low-Side-Schalter aufweist, wobei die MOSFETs (T1 - T4) mittels mindestens eines Gate-Treiberbausteins (3, 4) angesteuert werden, wobei die Gate-Anschlüsse (G1 - G4) der MOSFETs (T1 - T4) einzeln herausgeführt sind, wobei den Gate-Anschlüssen (G1 - G4) zuund einstellbare Widerstände (R) zugeordnet sind, wobei beim Einschalten der High-Side-Schalter die Gate-Source-Spannungen an den Low-Side-Schaltern und beim Einschalten der Low-Side-Schalter die Gate-Source-Spannungen an den High-Side-Schaltern erfasst werden, wobei die Gate-Source-Spannungen der High-Side-Schalter untereinander und die Gate-Source-Spannungen der Low-Side-Schalter untereinander verglichen werden, um ein jeweiliges PTO-Verhalten zu bestimmen, wobei bei einem abweichenden Verhalten mindestens ein Widerstand (R) verändert und/oder zeitlich verändert zugeschaltet wird, um das PTO-Verhalten anzugleichen, sowie eine Vorrichtung (1).

## Beschreibung

Die Erfindung betrifft ein Verfahren und eine Vorrichtung zum Betreiben einer Halbbrückenschaltung aus diskreten MOSFETs.

Halbbrückenschaltungen aus diskreten MOSFETs werden für verschiedene Anwendungen benötigt. Beispielsweise kommen diese in einem Wechselrichter eines Traktionsnetzes eines Elektro- oder Hybridfahrzeuges zum Einsatz.

Ein Problem bei Halbbrückenschaltungen aus MOSFETs ist das sogenannte PTO (parasitic turn-on). Die Ursache hierfür ist, dass beim Kommutieren des Stroms die Gate-Source-Kapazität des abgeschalteten MOSFET aufgeladen wird. In Reihe zu der Gate-Source-Kapazität liegt die Gate-Drain-Kapazität. Durch den Strom in die Kapazitäten kann sich am Gate eine Spannung aufbauen, die den MOSFET durchschaltet. Zur Lösung dieses Problems ist ein sogenanntes Active Miller Clamping bekannt, bei dem ein Widerstand parallel zur Gate-Drain-Kapazität geschaltet wird, um ein zu starkes Aufladen zu verhindern, wobei der Widerstand ausreichend klein sein muss. Derartige Schaltungen sind beispielsweise aus der US 10 917 081 B1 oder der US 2018/0115311 A1 bekannt.

Ein weiteres Problem ist die begrenzte Stromtragfähigkeit von MOSFETs, insbesondere wenn diese den Antriebsstrom für elektrische Maschinen liefern. Verschärft wird dieses Problem bei Verwendung von SiC-MOSFETs. Hier ist es häufig notwendig, mindestens zwei oder mehr MOSFETs parallel zu schalten, um die Stromtragfähigkeit zu erhöhen.

Aufgrund der Tatsache, dass die Leistungs-MOSFETs diskrete Bauelemente sind, verursachen die Toleranzen zwischen den diskreten MOSFETs neue Probleme.

Der Erfindung liegt das technische Problem zugrunde, ein Verfahren zum Betreiben einer Halbbrückenschaltung aus diskreten MOSFETs zu verbessern sowie eine geeignete Vorrichtung zu schaffen.

Die Lösung des technischen Problems ergibt sich durch ein Verfahren mit den Merkmalen des Anspruchs 1 sowie eine Vorrichtung mit den Merkmalen des Anspruchs 6. Weitere vorteilhafte Ausgestaltungen der Erfindung ergeben sich aus den Unteransprüchen.

Vorgeschlagen wird ein Verfahren zum Betreiben einer Halbbrückenschaltung aus diskreten MOSFETs, wobei die Halbbrückenschaltung mindestens zwei parallelgeschaltete High-Side-Schalter und mindestens zwei parallelgeschaltete Low-Side-Schalter aufweist. Die MOSFETs werden mittels mindestens eines Gate-Treiberbausteins angesteuert, wobei die GateAnschlüsse der MOSFETs einzeln herausgeführt sind, wobei den Gate-Anschlüssen zu- und einstellbare Widerstände zugeordnet sind, mittels derer ein Active Miller Clamping durchgeführt werden kann. Beim Einschalten der High-Side-Schalter werden die Gate-Source-Spannungen an den Low-Side-Schaltern und beim Einschalten der Low-Side-Schalter werden die Gate-Source-Spannungen an den High-Side-Schaltern erfasst. Weiter werden die Gate-Source-Spannungen der High-Side-Schalter untereinander und die Gate-Source-Spannungen der Low-Side-Schalter untereinander verglichen, um ein jeweiliges PTO-Verhalten zu bestimmen. Insbesondere wird dabei untersucht, wie hoch die Gate-Source Spannung ist und/oder wie lange die Gate-Source-Spannung oberhalb der Gate-Threshold-Spannung anliegt. Wird dann ein abweichendes PTO-Verhalten erfasst, wird mindestens ein Widerstand verändert und/oder zeitlich verändert zugeschaltet, um das PTO-Verhalten anzugleichen, so dass die MOSFETs gleichmäßig thermisch belastet werden. Ist beispielsweise die Gate-Source-Spannung eines MOSFETs höher als die der anderen, so kann dessen Widerstand für das Active Miller Clamping reduziert werden und/oder schneller als die anderen Widerstände zugeschaltet werden. Kann hingegen der Widerstand nicht mehr erniedrigt werden, so können auch die Widerstände der andren MOSFETs erhöht werden. Dies verschlechtert zwar deren PTO-Verhalten, führt aber ebenfalls zu einer Symmetrierung der thermischen Belastung. Gleiches gilt für die Zuschaltgeschwindigkeit. Diese Anpassung des Active Miller Clamping kann fortlaufend in jedem Taktzyklus der Halbbrücke durchgeführt werden oder periodisch nach einer gewissen Anzahl von Taktzyklen der Halbbrücke.

In einer Ausführungsform wird zusätzlich eine Temperatur der MOSFETs erfasst oder ermittelt, um so die Wirkung der Symmetrierung zu überwachen.

Zusätzlich kann in Abhängigkeit einer Temperaturdifferenz zwischen den MOSFETs mindestens ein Widerstand verändert werden und/oder zeitlich verändert zugeschaltet werden, um so die Temperaturdifferenz zu reduzieren.

In einer weiteren Ausführungsform wird die Temperatur des MOSFETs mittels einer Kennlinie der Gate-Threshold Spannung über der Temperatur ermittelt, da so die Chiptemperatur genauer ermittelt werden kann im Vergleich zu einem räumlich getrennten Temperatursensor. Derartige Kennlinien sind typischerweise Bestandteil der Datenblätter der Hersteller. Allerdings stellt die Kennlinie den Verlauf für ein Soll-MOSFET dar.

In einer weiteren Ausführungsform werden daher in einem Initialisierungsschritt vor der Inbetriebnahme der Halbbrücke die einzelnen Gate-Threshold-Spannungen bei einer aktuellen Temperatur erfasst und daraus angepasste Kennlinien für jeden MOSFET erzeugt und abgespeichert. Die Anpassung der Kennlinie erfolgt dabei vorzugsweise durch eine Verschiebung in Y-Richtung, so dass der Messpunkt (gemessene Gate-Threshold-Spannung bei der aktuellen Temperatur) auf der Kennlinie liegt. Hierdurch wird die Genauigkeit der Temperaturermittlung erheblich verbessert.

Hinsichtlich der vorrichtungsmäßigen Ausgestaltung wird vollinhaltlich auf die vorangegangenen Ausführungen Bezug genommen.

Die MOSFETs sind vorzugsweise SiC-MOSFETs. Die Widerstände für das Active Miller Clamping können separate Widerstände sein oder aber in den Gate-Treiberbaustein integriert sein.

Die Halbbrückenschaltung kann beispielsweise in einem Wechselrichter eines Traktionsnetzes eines Elektro- oder Hybridfahrzeuges zum Einsatz kommen.

Die Erfindung wird nachfolgend anhand eines bevorzugten Ausführungsbeispiels näher erläutert. Die Fig. zeigen:
- Fig. 1: eine schematische Darstellung einer Vorrichtung zum Betreiben einer Halbbrückenschaltung und
- Fig. 2: eine schematische Kennlinie der Gate-Threshold-Spannung über der Temperatur.

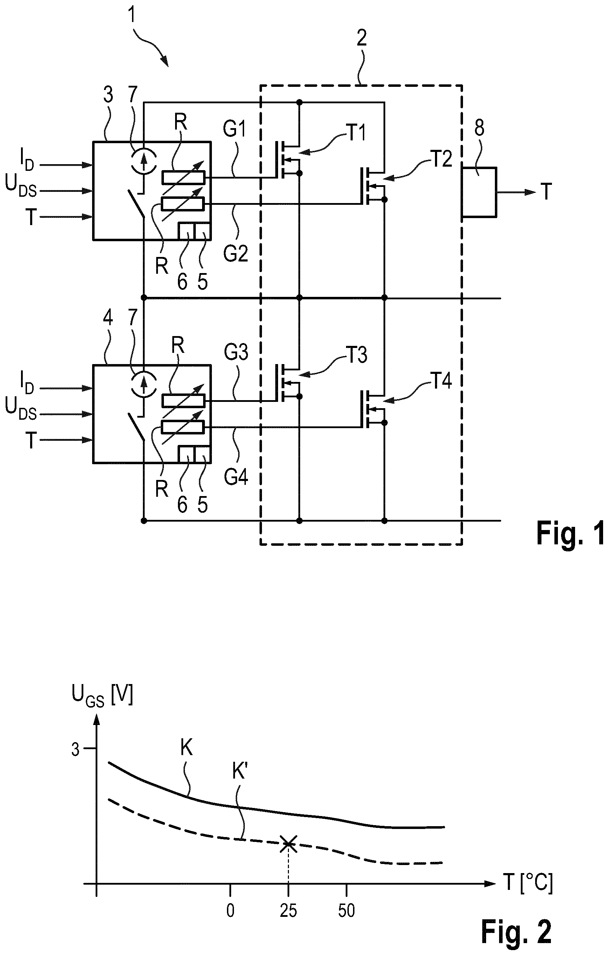

In der Fig. 1 ist schematisch eine Vorrichtung 1 zum Betreiben einer Halbbrückenschaltung 2 dargestellt, wobei zwei MOSFETs T1, T2 als High-Side-Schalter und zwei MOSFETs T3, T4 als Low-Side-Schalter parallelgeschaltet sind. Die Anzahl der parallelgeschalteten Transistoren kann dabei auch größer sein und beispielsweise zwischen 4 - 8 liegen. Die Gate-Anschlüsse G1 - G4 sind dabei einzeln herausgeführt. Dabei sind die Gate-Anschlüsse G1, G2 der High-Side-Schalter mit einem Gate-Treiberbaustein 3 und die Gate-Anschlüsse G3 und G4 der Low-Side-Schalter mit einem Gate-Treiberbaustein 4 verbunden, wobei die Gate-Treiberbausteine 3, 4 derart ausgebildet sind, die Gate-Anschlüsse G1 - G4 voneinander unabhängig anzusteuern. Die Halbbrückenschaltung 2 weist weiter mindestens eine nicht dargestellte Spannungsmesseinrichtung und mindestens eine nicht dargestellte Strommesseinrichtung auf, um die jeweilige Drain-Source-Spannung U_{DS} und den Drainstrom I_{D} durch die Parallelschaltung zu messen. Diese Messwerte werden jeweils dem zugeordneten Gate-Treiberbausteinen 3, 4 zugeführt. Die Gate-Treiberbausteine 3, 4 können dabei als strom- oder spannungsgesteuerte Gate-Treiberbausteine 3, 4 ausgebildet sein. Die Gate-Treiberbausteine 3, 4 weisen weiter mindestens einen Speicher 5 und einen Mikroprozessor 6 auf, wobei diese aber auch als separate Bauteile ausgebildet sein können. Weiter sind die Gate-Treiberbausteine 3, 4 derart ausgebildet, die Gate-Threshold-Spannung der einzelnen MOSFETs T1, T2 bzw. T3, T4 zu erfassen. Weiter weisen die Gate-Treiberbausteine 3, 4 zuschaltbare Stromquellen 7 auf, um einen konstanten Drainstrom I_{D} einzustellen. Weiter weisen die Gate-Treiberbausteine 3, 4 zuund einstellbare Widerstände R auf.

In dem Speicher 5 ist eine Kennlinie K der Gate-Threshold-Spannung U_{GS} über der Temperatur T abgespeichert (s. Fig. 2). Diese Kennlinie K wird vorzugsweise vom Hersteller vorgegeben und kann einem Datenblatt entnommen werden. Diese Kennlinie K ist stark toleranzbehaftet. Dabei sei angemerkt, dass vorliegend unter dem Begriff Kennlinie auch eine Look-up-Tabelle verstanden wird. Weiter ist der Halbbrückenschaltung 2 mindestens ein Temperatursensor 8 zugeordnet, der beispielsweise an einem Kühlkreislauf der Halbbrückenschaltung 2 angeordnet ist, wobei die Messwerte der Temperatur T ebenfalls dem Gate-Treiberbaustein 3, 4 zugeführt werden.

Aufgrund von Herstellungstoleranzen sind die MOSFETs T1 - T4 hinsichtlich ihrer Parameter (z. B. Gate-Threshold-Spannung) unterschiedlich. Dies würde im Betrieb ohne Gegenmaßnahmen zu einer unterschiedlich starken Belastung der MOSFETs T1 - T4 führen, so dass stärker belastete MOSFETs T1 - T4 eher ausfallen würden.

Zur Vermeidung dieses Problems erfolgt vor der eigentlichen Inbetriebnahme ein Initialisierungsschritt. Dabei wird angenommen, dass vor dem Start die Halbbrückenschaltung 2 thermisch stabil ist und die vom Temperatursensor 8 gemessene Temperatur T mit der Temperatur Tj der MOSFETs T1 - T4 übereinstimmt. Die Gate-Treiberbausteine 3, 4 bestimmen nun nacheinander die Gate-Threshold-Spannung U_{GS} jedes MOSFETs T1 - T4. Aufgrund der Messwerte für die Gate-Threshold-Spannung U_{GS} bei der aktuellen Temperatur T wird dann für jeden MOSFET T1 - T4 die Kennlinie K durch eine Verschiebung angepasst, so dass die Kennlinie durch den Messpunkt geht. Die derart angepassten Kennlinien K' für jeden MOSFET T1 - T4 werden dann abgespeichert. Dabei wird für die Messung der Drainstrom I_{D} durch die Stromquellen 7 auf niedrigem Niveau konstant gehalten (z. B. 20 mA), so dass es während der Messung zu keiner nennenswerten Temperaturerhöhung kommt.

Im Betrieb der Halbbrückenschaltung 2 werden dann wieder die Gate-Threshold-Spannungen U_{GS} der MOSFETs T1 - T4 bestimmt und daraus mittels der angepassten Kennlinien die jeweilige Temperatur T der einzelnen MOSFETs T1 - T4 bestimmt.

Im Betrieb werden die High-Side-Schalter und die Low-Side-Schalter wechselweise durchgeschaltet und gesperrt. Dabei werden an den Gate-Anschlüssen G1 - G4 der MOSFET T1 - T4, die gesperrt werden sollen, die Widerstände R zugeschaltet, um so ein aktives Miller Clamping durchzuführen und die PTO-Neigung zu reduzieren. Dabei wird die Gate-Source-Spannung an den beiden MOSFETs gemessen und miteinander verglichen, um deren PTO-Verhalten bzw. deren PTO-Neigung zu vergleichen. Ergibt dann beispielsweise der Vergleich, dass die Gate-Source-Spannung am MOSFET 3 höher und länger über der Gate-Threshold-Spannung liegend ist als die Gate-Source-Spannung am MOSFET T4, so wird im nächsten Taktzyklus (wenn MOSFET T3 und T4 wieder sperren sollen) der zugeordnete Widerstand R am Gate-Anschluss G3 erniedrigt und etwas früher zugeschaltet. Die Gate-Source-Spannungen werden wieder ermittelt und verglichen, ob sich das PTO-Verhalten symmetriert hat. Gegebenenfalls, falls noch immer eine Abweichung festgestellt wird, wird der Widerstand R beim nächsten Taktzyklus weiter erniedrigt bzw. noch schneller zugeschaltet. Sind die Maßnahmen zur Reduzierung der PTO-Neigung an einem MOSFET ausgeschöpft, kann dann entsprechend der Widerstand des anderen MOSFETs auch vergrößert werden, was zwar dessen PTO-Verhalten verschlechtert, aber die MOSFETs symmetriert. Zusätzlich kann über die zuvor beschriebene Temperaturermittlung mittels der angepassten Kennlinie K' die Symmetrierung überprüft werden.

Ein bevorzugtes Anwendungsgebiet ist der Einsatz in einem Wechselrichter eines Traktionsnetzes eines Elektro- oder Hybridfahrzeuges, wobei dann drei Halbbrückenschaltungen 2 verwendet werden, wobei der Initialisierungsschritt parallel in den drei Halbbrücken erfolgen kann.

In der Fig. 2 ist eine Kennlinie K der Gate-Threshold-Spannung U_{GS} sowie angepasste Kennlinie K` aufgrund einer Gate-Threshold-Spannungsmessung in dem Initialisierungsschritt über der Temperatur T für ein MOSFET T1 - T4 dargestellt.

### Bezugszeichenliste

- 1): Vorrichtung
- 2): Halbbrückenschaltung
- 3): Gate-Treiberbaustein
- 4): Gate-Treiberbaustein
- 5): Speicher
- 6): Mikroprozessor
- 7): Stromquellen
- 8): Temperatursensor
- R: Widerstand
- G1 - G4: Gateanschlüsse
- I_{D}: Drainstrom
- K: Kennlinie
- K': angepasste Kennlinie
- T: Temperatur
- T1 - T4: MOSFETs
- U_{DS}: Drain-Source-Spannung
- U_{GS}: Gate-Threshold-Spannung

## Patentansprüche

1. Verfahren zum Betreiben einer Halbbrückenschaltung (2) aus diskreten MOSFETs (T1 - T4), wobei die Halbbrückenschaltung (2) mindestens zwei parallelgeschaltete High-Side-Schalter und mindestens zwei parallelgeschaltete Low-Side-Schalter aufweist, wobei die MOSFETs (T1 - T4) mittels mindestens eines Gate-Treiberbausteins (3, 4) angesteuert werden, wobei die Gate-Anschlüsse (G1 - G4) der MOSFETs (T1 - T4) einzeln herausgeführt sind, wobei den Gate-Anschlüssen (G1 - G4) zu- und einstellbare Widerstände (R) zugeordnet sind, wobei beim Einschalten der High-Side-Schalter die Gate-Source-Spannungen an den Low-Side-Schaltern und beim Einschalten der Low-Side-Schalter die Gate-Source-Spannungen an den High-Side-Schaltern erfasst werden, wobei die Gate-Source-Spannungen der High-Side-Schalter untereinander und die Gate-Source-Spannungen der Low-Side-Schalter untereinander verglichen werden, um ein jeweiliges PTO-Verhalten zu bestimmen, wobei bei einem abweichenden Verhalten mindestens ein Widerstand (R) verändert und/oder zeitlich verändert zugeschaltet wird, um das PTO-Verhalten anzugleichen.

2. Verfahren nach Anspruch 1, **dadurch gekennzeichnet, dass** zusätzlich eine Temperatur (T) der MOSFETs (T1 - T4) erfasst oder ermittelt wird.

3. Verfahren nach Anspruch 2, **dadurch gekennzeichnet, dass** in Abhängigkeit einer Temperaturdifferenz zwischen den MOSFETs (T1 - T4) mindestens ein Widerstand (R) verändert und/oder zeitlich verändert zugeschaltet wird.

4. Verfahren nach Anspruch 2 oder 3, **dadurch gekennzeichnet, dass** die Temperatur (T) der MOSFETs (T1 - T4) mittels einer Kennlinie (K) der Gate-Threshold-Spannung (U_{GS}) über der Temperatur (T) ermittelt wird.

5. Verfahren nach Anspruch 4, **dadurch gekennzeichnet, dass** in einem Initialisierungsschritt die einzelnen Gate-Threshold-Spannungen (U_{GS}) bei einer aktuellen Temperatur (T) erfasst werden und daraus angepasste Kennlinien (K`) für jeden MOSFET (T1 - T4) erzeugt und abgespeichert werden.

6. Vorrichtung (1) zum Betreiben einer Halbbrückenschaltung (2) aus diskreten MOSFETs (T1 - T4), wobei die Halbbrückenschaltung (2) mindestens zwei parallelgeschaltete High-Side-Schalter und mindestens zwei parallelgeschaltete Low-Side-Schalter aufweist, wobei die MOSFETs (T1 - T4) mit mindestens einem Gate-Treiberbaustein (3, 4) verbunden sind, wobei die Gate-Anschlüsse (G1 - G4) der MOSFETs (T1 - T4) einzeln herausgeführt sind, wobei den Gate-Anschlüssen (G1 - G4) zu- und einstellbare Widerstände (R) zugeordnet sind, wobei beim Einschalten der High-Side-Schalter die Gate-Source-Spannungen an den Low-Side-Schaltern und beim Einschalten der Low-Side-Schalter die Gate-Source-Spannungen an den High-Side-Schaltern erfasst werden, wobei die Gate-Source-Spannungen der High-Side-Schalter untereinander und die Gate-Source-Spannungen der Low-Side-Schalter untereinander verglichen werden, um ein jeweiliges PTO-Verhalten zu bestimmen, wobei bei einem abweichenden Verhalten mindestens ein Widerstand (R) verändert und/oder zeitlich verändert zugeschaltet wird, um das PTO-Verhalten anzugleichen.

7. Vorrichtung nach Anspruch 6, **dadurch gekennzeichnet, dass** die einstellbaren Widerstände (R) in den mindestens einen Gate-Treiberbaustein (3, 4) integriert sind.

8. Vorrichtung nach Anspruch 6 oder 7, **dadurch gekennzeichnet, dass** die Vorrichtung (1) derart ausgebildet ist, zusätzlich eine Temperatur (T) der MOSFETs (T1 - T4) zu erfassen oder zu ermitteln, wobei in Abhängigkeit einer Temperaturdifferenz zwischen den MOSFETs (T1 - T4) mindestens ein Widerstand (R) verändert und/oder zeitlich verändert zugeschaltet wird.

9. Vorrichtung nach einem der Ansprüche 6 bis 8, **dadurch gekennzeichnet, dass** die Vorrichtung (1) derart ausgebildet ist, dass die Temperatur (T) der MOSFETs (T1 - T4) mittels einer Kennlinie (K) Gate-Threshold-Spannung (U_{GS}) über der Temperatur (T) ermittelt wird.

10. Vorrichtung nach einem der Ansprüche 6 bis 9, **dadurch gekennzeichnet, dass** die Vorrichtung (1) derart ausgebildet ist, dass in einem Initialisierungsschritt die einzelnen Gate-Threshold-Spannungen (U_{GS}) bei einer aktuellen Temperatur (T) erfasst werden und daraus angepasste Kennlinien (K`) für jeden MOSFET (T1 - T4) erzeugt und abgespeichert werden.
